# EUROPEAN PATENT SPECIFICATION

(11) **EP 3 312 137 B1**
(45) Date of publication and mention of the grant of the patent: **24.02.2021**
(21) Application number: 16811071.6
(22) Date of filing: 15.06.2016
(51) Int. Cl.: B82Y 40/00, B82Y 30/00, C09D 1/00, C01B 32/05, C23C 16/50, C09D 5/08, C09D 7/61, C09D 7/40

(54) **DEPOSITION OF GRAPHENE LAYERS BY MEANS OF PLASMA-ENHANCED CHEMICAL VAPOUR DEPOSITION**
ABSCHEIDUNG VON GRAPHENSCHICHTEN MITTELS PLASMAVERSTÄRKTER CHEMISCHER DAMPFABSCHEIDUNG
DÉPÔT DE COUCHES DE GRAPHÈNE PAR DÉPÔT CHIMIQUE EN PHASE VAPEUR ASSISTÉ PAR PLASMA

(30) Priority: 18.06.2015 ES 201530864
(43) Date of publication of application: 25.04.2018
(73) Proprietor: Consejo Superior De Investigaciones Científicas, 28006 Madrid (ES)
(72) Inventor: MUÑOZ GÓMEZ, Roberto, 28049 Madrid (ES); GARCÍA HERNÁNDEZ, María del Mar, 28049 Madrid (ES); GÓMEZ-ALEIXANDRE FERNÁNDEZ, Cristina, 28049 Madrid (ES)
(74) Representative: Pons Ariño, Angel
(86) International application number: PCT/ES2016/070451
(87) International publication number: WO 2016/203083

(56) References cited:
- WO-A1-2014/112953
- WO-A2-2014/110446
- US-A1- 2012 196 074
- US-A1- 2013 243 969
- SUBRATA GHOSH ET AL: "Evolution and defect analysis of vertical graphene nanosheets", JOURNAL OF RAMAN SPECTROSCOPY, vol. 45, no. 8, 1 August 2014 (2014-08-01) , pages 642-649, XP055337783, GB ISSN: 0377-0486, DOI: 10.1002/jrs.4530
- ROBERTO MUÑOZ ET AL: "Fast and non-catalytic growth of transparent and conductive graphene-like carbon films on glass at low temperature", JOURNAL OF PHYSICS D: APPLIED PHYSICS, INSTITUTE OF PHYSICS PUBLISHING LTD, GB, vol. 47, no. 4, 24 December 2013 (2013-12-24), page 45305, XP020256456, ISSN: 0022-3727, DOI: 10.1088/0022-3727/47/4/045305 [retrieved on 2013-12-24]
- MUNOZ, R. ET AL.: 'Fast and non-catalytic growth of transparent and conductive graphene-like carbon films on glass at low temperature.' JOURNAL OF PHYSICS D: APPLIED PHYSICS vol. 47, no. 4, 2013, pages 1 - 9, XP020256456
- 'Graphene: Synthesis and Applications' vol. 15, no. 3, 2011, XP055270323
- MUNOZ, R. ET AL.: 'Review of CVD synthesis of graphene' CHEMICAL VAPOR DEPOSITION vol. 19, no. 10-11-, 2013, pages 297 - 322, XP055264398
- DUMME, L.F. ET AL.: 'Growth of nano-textured graphene coating across highly porous stainless supports towards corrosion resistant coatings' CARBON vol. 87, 24 February 2015, pages 395 - 408, XP029204878
- GHOSH, S. ET AL.: 'Evolution and defect analysis of vertical graphene nanosheets.' JOURNAL OF RAMAN SPECTROSCOPY vol. 45, no. 8, 2014, pages 642 - 649, XP055337783
- PARK, H.J. ET AL.: 'Direct synthesis of multi-layer graphene film on various substrates by microwave plasma at low temperature.' THIN SOLID FILMS vol. 587, 31 July 2015, pages 8 - 13, XP055503906 DOI: 10.1016/J.TSF.2015.01.011

## Description

The invention relates to a deposition process of graphene layers onto a substrate being performed by plasma-assisted chemical vapour deposition, said graphene layers comprising nanocrystals of time and temperature controllable sizes interconnected by amorphous phase.

### STATE OF THE ART

Graphene, the one atom thick layer of carbon, uniquely combines outstanding physical properties that justify its nickname of a "miracle material". A number of these properties -mechanical stiffness, strength, elasticity, electrical and thermal conductivity- are extreme. Moreover, the combination of these properties suggests that graphene could replace current materials in existing applications rapidly. This versatility could justify the common inconveniences of switching to a new technology in industrial processes. One example of this is the combination of transparency and conductivity that will find use, for example, in photovoltaic solar cells or flexible electronics as a cheap transparent electrode.

The first isolation of graphene was performed in 2004 by using mechanical exfoliation of graphite, successively thinning the graphite sample. This fact astonished the scientific community because graphene was thought to be a theoretical material which could not exist, thermodynamically unstable and unable to withstand thermal fluctuations. Materials scientists were unaware of the existence of stable, isolated and freestanding 2D crystals. After this first demonstration, the mechanical exfoliation method allowed researchers worldwide to isolate graphene microlayers of suitable quality to demonstrate locally their outstanding physical properties. The main drawback of this method, however, was that only small area sheets with uncontrolled number of exfoliated layers could be produced.

It is worth briefly mentioning that one key question regarding exfoliated graphene is its inherent high quality, related to the number of defects and degree of crystallinity. The quality of small "flakes" samples depends on the defect density and structural order of the precursor graphite. A typical precursor graphite of high purity and quality is highly oriented pyrolytic graphite (HOPG). This material is obtained from pyrolysis of organic compounds. Pyrolytic graphite, obtained by heat treatment of pyrolytic carbon or by Chemical Vapour Deposition (CVD) above 2500 K, exhibits a high degree of preferred crystallographic orientation perpendicular to the surface. Subsequent annealing under conditions of high compressive stress at approximately 3300 K results in HOPG. Thus, HOPG incorporates a low impurity level of the order of ppm and a lateral grain size typically of the order of mm. That's why exfoliated sheets exhibit local properties close to the theoretical limits; the sheets can be part of one grain and therefore, isolated single crystals.

Simultaneously, other methods to produce large area graphene samples with suitable lateral size for applications have been developed and continue their development, such as SiC sublimation and chemical vapour deposition (CVD). For the SiC sublimation method, the major concerns are the high price of the SiC substrate and the high temperatures over 1300 °C used in the method. Moreover, the method is limited to its inherent substrate if there is no transference of the film to other surfaces. The other method is the "bottom up" growth by CVD. Currently, numerous examples of large area graphene synthesis by CVD can be found in the literature and the CVD of large area graphene layers has become a hot topic in material science and technology.

The standard CVD processes are based on heterogeneous catalysis of organic precursors and performed on metal substrates at much lower temperature and pressure (less than 1350 K and 1 Atm), than those mentioned in HOPG and SiC. The crystallization mechanism is quite different in both cases. Bulk 3D pyrolytic graphite has a limited degree of crystallization if annealed at low temperature and pressure. Extreme thermodynamic conditions are essential for a large crystal size in bulk carbon materials. And extreme temperatures are essential in the evaporation of the SiC surface. As the goal in CVD of graphene is not a 3D, but a 2D material, the process of heterogeneous catalysis over transition metals has proven to be effective. The metal performs the two different roles of catalyst and substrate. It favours the decomposition of CVD carbon precursors at lower temperature, while 2D pure graphene layer is formed over the entire surface following the stages of "nucleation" of carbon radicals and continuous "growth".

As a result of this mechanism, in the case of large area synthesis by CVD, graphene films exhibit a polycrystalline structure wherein the final film is a result of the coalescence of multiple domains. This process concludes when the metal is saturated or its surface is completely covered being quite similar to the "catalyst poisoning" in a typical catalytic process. Some reports have already appeared on the synthesis of millimetre-size single crystals by catalytic CVD, controlling the thermodynamics and kinetics of the nucleation and growth processes. Even wafer size single crystal graphene has been claimed recently.

Catalytic CVD has some drawbacks at present. On one hand, the transference of the film to the desired substrate for usage normally induces wrinkles, contamination or even breakage because the underlying metal has to be chemically removed. On the other hand, large energy consumption at the typical synthesis temperature, and the temperature itself, make the process incompatible with current production technologies. Difficulties were also encountered when growing large area multilayer films on functional substrates. In this scenario, the game changing breakthrough would be the development of CVD processes to deposit high quality graphene layers on arbitrary substrates, at low temperature.

In recent times, many approaches have been developed in an attempt to partially or fully solve these aspects. Parallel routes have been tested by many groups in this area that include low temperature synthesis on metals by plasma assisted CVD, direct synthesis on desired dielectric substrates, commonly at high temperature, without plasma technology and finally the combination of both, namely, direct synthesis on desired substrates at low temperature by means of plasma assisted deposition. Up to now, the main CVD technologies that have been used in graphene synthesis include, among others, radio frequency plasma enhanced CVD (RF-PECVD), microwave plasma CVD (MPCVD) and Electron Cyclotron Resonance CVD (ECR-CVD) [H. Medina, Y-C. Lin, C. Jin, C-C. Lu, C-H. Yeh, K-P. Huang, K. Suenaga, J. Robertson, P-W. Chiu, Adv. Func. Mater. 2012, 22, 2123].

First, for low temperature synthesis on metals by plasma assisted techniques, high quality graphene has been grown by MPCVD on Cu foils at 700°C and between 450°C-750°C on Ni, the quality of these films being comparable to those grown by thermal CVD. Large area roll-to-roll approaches to grow graphene on Cu foils (294 mm wide) and Al foils at 300°C-400°C by surface wave plasma assisted CVD has been also performed using CH₄/H₂/Ar mixtures. Graphene films with few layer structure have been also deposited on Cu at temperatures as low as 240°C using a gas mixture of C₂H₂ and Ar by MPCVD. These films show smaller graphene domain sizes compared to graphene deposited by thermal CVD. Multilayer graphene has been also deposited by RF-PECVD at 500°C on Cu with acceptable qualities and on Ni at 650°C using traces of CH₄ In all these examples post transfer process is needed. In this area of research two more approaches could be included. On the one hand, the synthesis at low temperature by using metal alloys acting as a catalyst. On the other hand, the use of Ni or Cu films at high synthesis temperatures over 1000°C which are subsequently evaporated, which effectively avoids the post-transfer processes. Although the evaporation of the catalyst is not complete in the case of Ni, the monolayer graphene exhibits optoelectronic properties that exceed the properties of transferred films.

A second route involves direct synthesis on desired substrates normally at elevated temperatures and without plasma assistance. Atmospheric Pressure CVD (APCVD) synthesis of monolayer or few layer graphene has been performed on Si₃N₄ at 1000°C and 1150°C resulting in continuous films with dozens of nm sized domains and sheet resistance of 3 kΩ or less. Also, APCVD synthesis has been used on sapphire (Al₂O₃) between 1450°C and 1650°C with CH4 ₄as precursor with mobility over 2000 cm^{2/}V·s for monolayer films- and at 950°C but with detrimental effects on electronic properties. Molecular beam epitaxy (MBE) from highly ordered pyrolytic graphite (HOPG) sublimation at 1100°C has also been tested on sapphire but the films presented small domain size, not usual at this temperature. There have also been published results of graphene grown by APCVD on SiO₂ substrates at 1000°C with CH₄ as precursor with sheet resistance around 5k Ω, and at 1100°C that show outstanding results with sheet resistances around 800 Ω and transmittance of 91% but in processes that take from 6 to 10 hours. Few layer graphene on h-BN flakes has also been deposited at 1000°C by APCVD. Synthesis of layered graphene flakes on MgO nanocrystal powder has been also carried out by low pressure CVD at temperatures between 325°C to 875C using acetylene and cyclohexane respectively, but optoelectronic properties have not been tested and Raman spectra of these samples exhibit the overlap of broadened G and D modes. In all these experiments the high temperatures limit the compatibility of these processes with microelectronic industrial processes.

Combining both ideas implicit above, many groups have faced the challenge of direct synthesis of graphene films on desired substrates at low temperatures by means of plasma assisted deposition. Graphene flakes have been synthesized by MPCVD at 700°C on various dielectric substrates (quartz, SiO₂). [A. Malesevic, R. Vitchev, K. Schouteden, A. Volodin, L. Zhang, G. Van Tendeloo, A. Vanhulsel, C. Van Haesendonck, Nanotech. 2008, 19, 305604]. Although Raman spectra have shown the high quality of the films, functional characterization has not been included. Remote PECVD has been also successfully applied in the direct synthesis of few layer nanographene type material at 550°C by using CH₄ plasma on different dielectric substrates [L. Zhang, Z. Shi, Y. Wang, R. Yang, D. Shi, G. Zhang, Nano Res. 2011, 4(3), 315.] In this case the processes have taken a few hours and the best result on glass was a sheet resistance of 7 kΩ with transmittance of 85% and 40 kΩ on quartz with transmittance of 92%. Recently a much more rapid approach by using ECR-CVD has been published [H. Medina, Y-C. Lin, C. Jin, C-C. Lu, C-H. Yeh, K-P. Huang, K. Suenaga, J. Robertson, P-W. Chiu, Adv. Func. Mater. 2012, 22, 2123]. The authors ensure the synthesis of nanographene films on pure SiO₂, glass and quartz at low temperature (400°C to 750°C) and in few minutes by using C₂H₄/Ar plasma. Although the exact synthesis temperature is not defined in each case, the published results of nanographene films on quartz exhibit outstanding transmittance from 94% to 82% and sheet resistances from 20 kΩ to 7 kΩ. Graphene films have been also produced by using a critical PECVD (c-PECVD) growth method, in which a H₂ plasma has been introduced during graphene growth, in a critical equilibrium state between H₂ plasma etching and CH₄ or C₂H₄ plasma growth [Dacheng Wei, Yunhao Lu, Cheng Han, Tianchao Niu, Wei Chen, y Andrew Thye Shen Wee, Angew. Chem. Int. Ed. 2013, 52, 14121] [Donghua Liu, Wei Yang, Lianchang Zhang, Jing Zhang, Jianling Meng, Rong Yang, Guangyu Zhang, Dongxia Shi, Carbon. 2014, 72, 387.] These two methods have some drawbacks. In one case, the substrate has suffered a precleaning and annealing step at 1000°C, as in the case of the synthesis on metals. In the second case the Raman spectra show the low quality of the nanographene with a secondary fine structure inside the graphene flakes and poor electronic properties. Moreover, two or three synthesis steps are needed in both cases and crystalline or semiconducting substrates have been used.

Finally, there have been many developments including PECVD or molecular beam epitaxy (MBE) techniques and epitaxial or heteroepitaxial growth at low temperatures but those approaches are limited to monocrystalline surfaces [US 2014/0273414 A1, CN102910614 A]

### DESCRIPTION OF THE INVENTION

The invention relates to a deposition process of graphene layers onto a substrate being performed by plasma-assisted chemical vapour deposition. The main advantages of the invention are:
- Controllable size of the graphene nanocrystals.
- Time dependent and temperature dependent size of the graphene nanocrystals.
- Enhanced quality of the transparent and conducting graphene layers.
- Low temperature process compared to catalytic processes.
- Direct growth. Transference of the graphene film is avoided.
- Negligible amount of impurities, in relation with the gases used during the synthesis.
- The resulting material thereof is ready to include functionalisation by chemicals or to be decorated with nanostructures.
- It has been demonstrated that the resulting material reaches a medium conductivity of 900 Ohm/m, keeping high transparency (over 92%). With the relevant modifications to the steps of the method, a person skilled in the art could reach a medium conductivity (∼4 kOhm/m) in continuous films, keeping high transparency (over 95%).

A first aspect of the present invention relates to a process of obtainment of a material deposited onto a substrate being performed by plasma-assisted chemical vapour deposition (herein the process of the invention), said material comprising
- At least a graphene layer and said graphene layer comprising nanocrystals interconnected by amorphous phase; and said process characterised in that it comprises the following steps:
   a) placing the substrate into a vacuum chamber previously set at a pressure lower than 10⁻⁴ mbar and under an atmosphere of argon and hydrogen;
   b) setting the substrate of step a) to a first substrate temperature T₁, wherein T₁ reaches values between 400°C and 700°C;
   c) activating the plasma and adding a carbon source into the vacuum chamber for a time t₁, wherein t₁ reaches different values of less than 60 min, obtaining a sample formed by the substrate and the deposited material precursor;
   d) setting the sample obtained in step c) to a second substrate temperature T₂, wherein T₂ is T₁ minus T₃ wherein T₃ reaches values between 30°C and 100°C for a time t₂ wherein t₂ is higher than t₁, and
   e) deactivating the plasma and cooling the sample obtained in step d).

The substrate of step a) should be stable at a temperature of 700°C. In a preferred embodiment, the substrate is selected from the list consisting of quartz, boron nitride, silicon carbide and sapphire. Even commercial glass substrates with finite roughness are feasible.

The term "plasma" of step c) refers herein to conventional plasma sources, such as radiofrequency RF-CVD (13.56 MHz) activation, microwave MW-CVD (2.41 GHz) activation and Electron Cyclotron Resonance ECR-CVD (2.41 GHz) activation. Other plasma sources or technologies are feasible.

Preferably, the plasma is an ECR-CVD plasma. The advantage of this source is the higher electron density, the higher ionization degree besides the larger efficiency in the dissociation of H₂, that is, enhanced atomic H activation at low power.

In another preferred embodiment of the invention, the carbon source of step c) is selected from the list consisting of methane CH₄, acetylene C₂H₂, ethylene C₂H₄ and a combination thereof. The sample obtained in step c) is formed by the substrate and a deposited material precursor comprising graphene nanodomains nucleated on the surface of the substrate with a controlled and minimized nucleation density and controllable area, nanometric in size.

In a more preferred embodiment of the invention, the nanocrystals forming the graphene layers have sizes between 10 nm and 400 nm. In a more preferred embodiment of the invention, the nanocrystals forming the graphene layers have sizes between 10 nm and 300 nm.

In another preferred embodiment of the present invention, the step (e) is carried out under an atmosphere of hydrogen and/or argon.

In another preferred embodiment of the present invention, the step (e) is carried out in a vacuum chamber.

Furthermore the present disclosure describes a material deposited onto a substrate obtained by the process invention, wherein said material comprises
- at least a graphene layer,
- and said graphene layer comprising nanocrystals interconnected by amorphous phase.

The term "time- and temperature-controllable sizes" refers herein to the size of the graphene nanocrystals reached when the substrate temperatures T₁ is set during a time t₁ and the T₂ is set during a time t₂. At higher T₁, the thickness is easily controlled to give monolayer films as a result. When T₁ and partial pressures are established, the higher t₁ is, the higher the nucleation density. This step controls the number of nuclei per unit area. After nucleation, T₂ is established to "edge growth", in the critical limit of nucleation and etching. If the selection is optimal, during t₂, enlargement of the size of the nuclei is performed. The higher t₂ is, the higher the nanocrystal size. As mentioned before, nanocrystals of sizes between 10 nm and 300 nm are obtained performing the process of the invention.

The following examples and drawings are provided by way of illustration and are not intended to be limiting of the present invention.

### BRIEF DESCRIPTION OF THE DRAWINGS

FIG.1. Raw Raman spectra of samples A, B, C. Spectrum C shows monolayer graphene on fused silica.
FIG.2. AFM image of sample A. A) Thickness measurement. The profile shows that the sample thickness is under 1 nm, signature of monolayer graphene. B) morphology of the sample surface.
FIG.3. AFM image of the morphology of the sample B. The image shows the enhanced grain size and the controlled nucleation density.
FIG.4. AFM image of sample C. Enhanced nucleation and grain size of monolayer domains.
FIG.5. AFM image of sample D, graphene on quartz. Enhanced nucleation and grain size of monolayer domains.
FIG.6. Transmittance spectra of sample E. Spectrum of graphene layer in black, obtained without the silica substrate contribution.
FIG. 7. AFM image of sample F in friction, graphene on quartz.
FIG. 8. Diagram of a thermal test. (1) Positive electrode (2) Negative electrode (3) Graphene (4) Silica and (5) Thermocouple.
FIG. 9. Thermal response of sample E with R = kΩ and transmittance greater than 83%.

### EXAMPLES

### Synthesis of graphene films

The present invention provides a method for the direct manufacturing of graphene films on arbitrary substrates, including dielectric, metallic and semiconducting surfaces. The manufacturing process is easily scalable, and the graphene film is prepared by using electron cyclotron resonance plasma-assisted chemical vapour deposition at moderate substrate temperature (≤ 700°C) during the whole process, without using metal catalyst. This method avoids damaging and expensive transfer processes of graphene films and improves compatibility with current manufacturing technologies. Graphene films have been grown in a remote electron cyclotron resonance chemical vapour deposition r-(ECR-CVD) system using Ar to activate and stabilize the ECR plasma, H₂ as a diluent and stabiliser (etching agent) of graphitic material and CH₄ - C₂H₂ as carbon precursor. The system mainly consists of a microwave power source, a two-zone chamber and a two-stage pumping system.

Table 1 describes the experimental conditions used for obtaining graphene films. These profiles are based on the variation of the partial pressures of the precursors (changing the atmosphere) and/or the temperature to obtain the graphene layer with controllable (within a certain range) grain size and number of layers.

All experiments have been performed on fused silica and quartz substrates.

**Table 1: Description of the experimental conditions for obtaining samples A, B, C, D, E and F. Deposition profiles of samples.**

| SAMPLE | | A | | B | C | D | E | F |
|---|---|---|---|---|---|---|---|---|
| POWER (W) | | 40 | | 100 | 100 | 100 | 100 | 100 |
| SUBSTRATE | | fused silica | | fused silica | fused silica | quartz | fused silica | quartz |
| GASES | | Ar/H₂/C₂H₂ | | H₂/C₂H₂ | H₂/C₂H₂ | H₂/C₂H₂ | H₂/C₂H₂ | H₂/C₂H₂ |
| PRESSURE (mbar) | | 1.2·10⁻¹ | | 3·10⁻² | 3·10⁻² | 5.4·10⁻² | 3·10⁻² | 5.4·10⁻² |
| T₁ | (°C) | 700 | | 625 | 675 | 700 | 675 | 670 |
| t₁ | (min) | 180 | | 4 | 4 | 4 | 2 | 20 |
| T₂ | (°C) | --- | | 575 | 625 | 650 | 625 | 660 |
| t₂ | (min) | --- | | 180 | 90 | 240 | 210 | 480 |
| AFM | image | Fig 2 | 2 B | Fig 3 | Fig 4 | Fig 5 | --- | Fig 7 |
| Raman Spectrum | | A | | B | C | --- | --- | --- |
| Transmittance | | --- | | --- | --- | --- | Fig 6 | --- |
| Sheet Resistance | | --- | | --- | -- | --- | ∼ 4 kOhm | --- |

By using remote plasma activation, the detrimental effects of the plasma ion etching on the quality of the films are avoided. The effective activation of carbon species (C₂H₂, CH₄) and the etching agent (H₂, H) in the plasma was followed by optical emission spectroscopy (OES). The nanostructure and the crystallinity of the films have been characterized by Atomic Force Microscopy (AFM) and Raman spectroscopy. The continuity, transmittance and sheet resistance have been characterized by UV-Vis-NIR spectrophotometry and point probe measurements. The process is reproducible and compatible with current optoelectronic manufacturing technologies.

### Characterization of the graphene films

Fundamental characterization of the structure of the samples A, B, C, D, E and F has been carried out by means of Raman spectroscopy (ENWAVE Optronics EZRaman-N) and AFM microscopy (NANOTEC Electronics Dulcinea Control System). The performance of the E has been characterized by means of UV-Vis-NIR spectrophotometry (SHIMADZU SolidSpec - 3700 Spectrophotometer) for transmittance and four point probe measurement (JANDEL RMS2 Universal Probe) with continuous current (from 1 µA -100 µA).

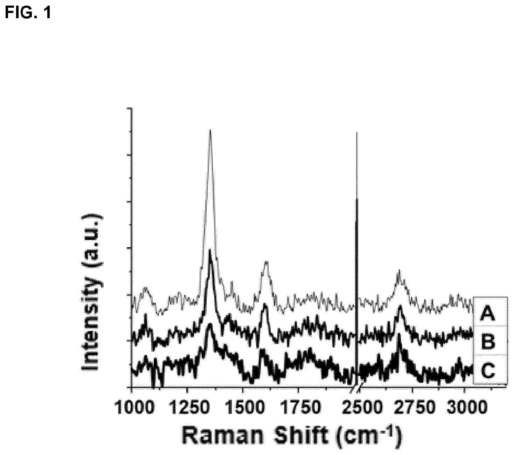

Figure 1 includes the raw Raman spectra of samples A, B and C.

For all the samples, the characteristic peaks of sp² bonding are observed in the Raman spectra: D peak centred at near 1350 cm⁻¹, G peak near 1580 cm⁻¹ and 2D peak centred at 2700 cm⁻¹. The G peak shift from the standard position at 1580 cm⁻¹ is really due to the appearance of the D' peak at 1620 cm⁻¹ that merges in the G peak for small grain sizes.

There are clear differences observed among the spectra. The spectrum of the sample A could be related to a monolayer or bilayer graphene film with small grain size, due to the similar intensities of the G and 2D peaks and quite high D peak. The intensity of the characteristic D peak, related to defects and grain boundaries, is quite strong in the case of samples B and C, sample C (high temperature) being the process with the smallest peak. This is a signature of enhanced grain size and quality. Another key difference is the intensity of the 2D peak in the spectrum of sample C, almost twice the G peak, and width, signature of monolayer graphene sheet. Higher 2D peak is a signature of enhanced quality and, in addition, in this sample C, the D peak is the smallest, in relation with grain boundaries.

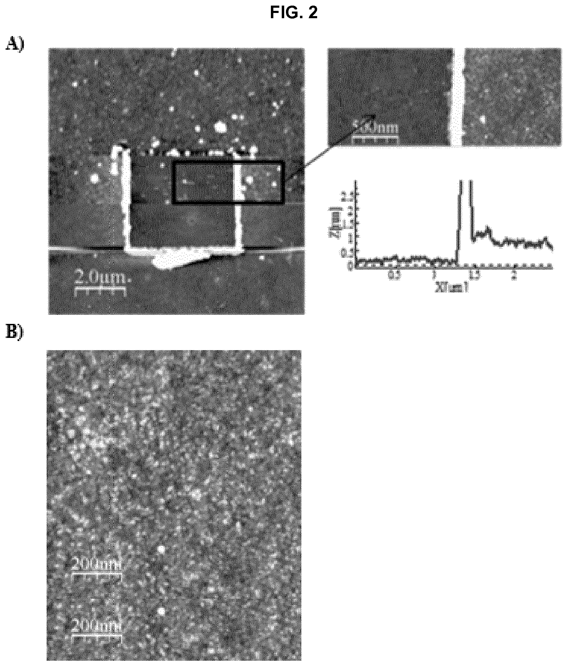

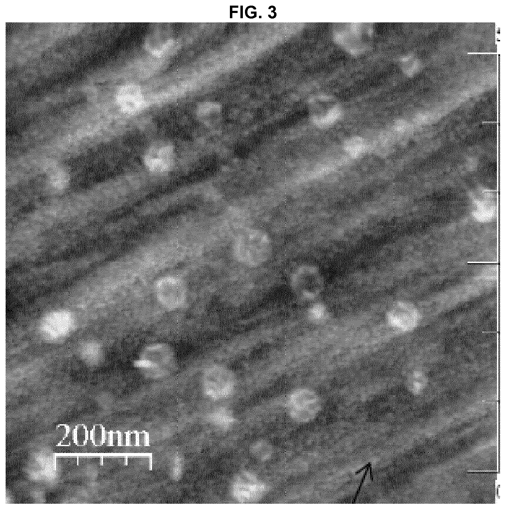

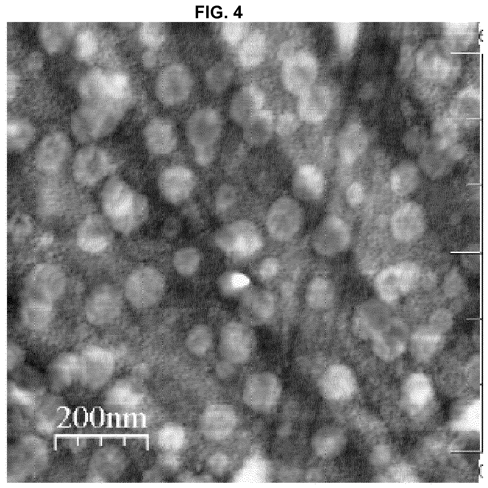

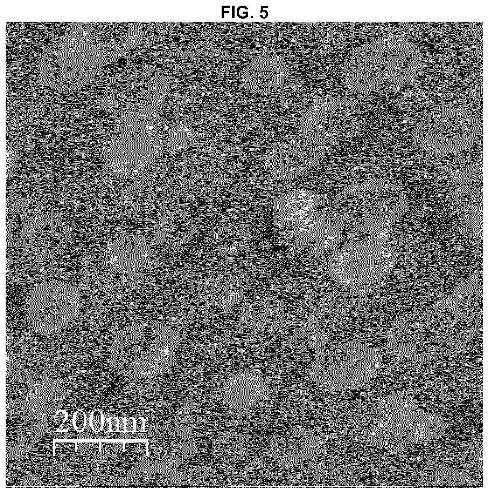

Figures 2, 3, 4 and 5 show the corresponding AFM images of the samples. Figure 2A and 2B corresponds to sample A. The measure in figure 2A shows that the thickness is less than 1 nm, a typical value of monolayer graphene on the silica surface. Figures 3 and 4 show the AFM images of the samples B and C respectively. Both samples show enlarged grain size over 100 nm, and an order of magnitude larger than sample A. Figure 5 show the AFM image of the sample D with enlarged grain size over 200 nm on quartz.

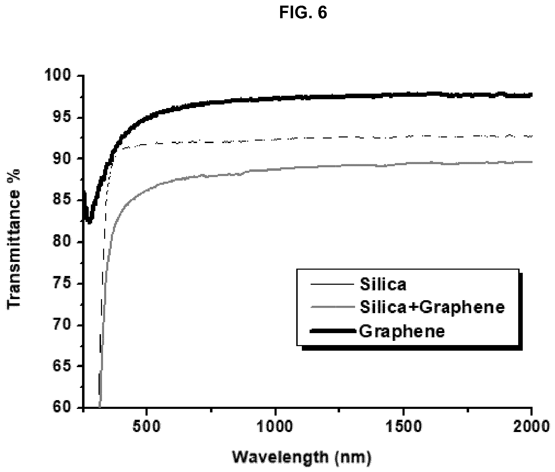

Figure 6 shows the transmittance spectra of sample E. We include the transmittance spectra of the substrate alone, the substrate with graphene and the graphene alone. The substrate and substrate with graphene spectra have been obtained with a reference spectrum in air (for 100% transmittance reference). The graphene alone spectrum is measured by previously obtaining a reference spectrum of the substrate (for 100% transmittance reference).

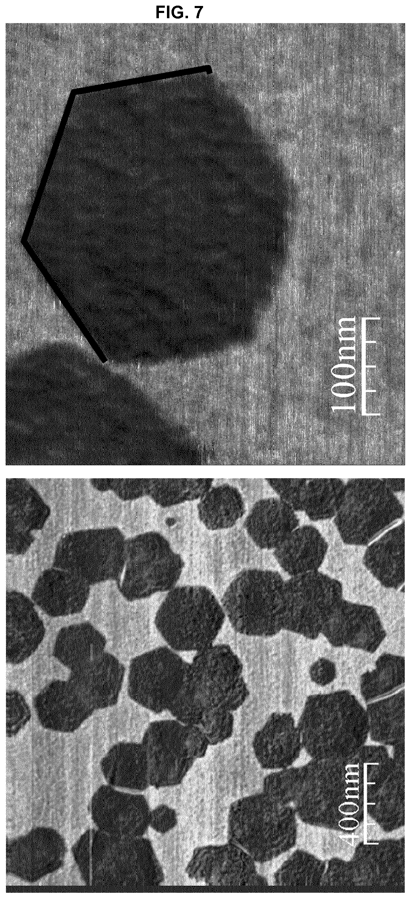

Figure 7 shows AFM images in friction of sample F. A grain size over 400 nm and being enlarged proportionally to the time of growth is observed. Enhanced nucleation and a crystal size of monolayer domains is observed.

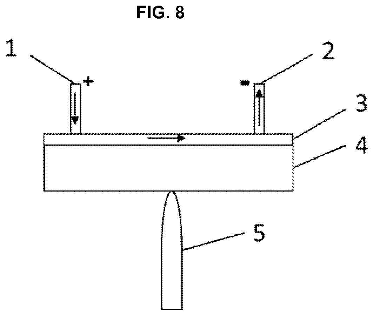

Figure 8 shows a diagram of a simple test to evaluate resistive thermal behaviour. The test was carried out on graphene films of sample E (3) onto the isolated silica substrate (4). The test consists of applying a voltage through two electrodes (1 and 2) to the surface of the sample on the side of the layer, and simultaneously measuring the temperature of the sample on the opposite side with the help of a thermocouple (5).

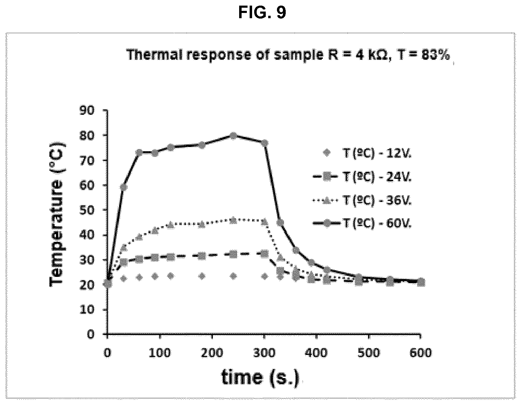

Figure 9 shows the results of the measurements on sample E. The transmittance data relates to the glass-coating assembly. Four tests at different power supplies, 12 V, 24 V, 36 V and 60 V, were carried out. The measurements were taken until reaching equilibrium, and the test lasted approximately 5 minutes. At the end of this time, the power (OFF) was disconnected and it was left to cool freely. It is observed that the glass has very quick heating and cooling rates, reaching the maximum in about 60 seconds. A proportionality between the voltage applied and the temperature reaches is also observed.

## Claims

1. A process of obtainment of a material deposited onto a substrate being performed by plasma-assisted chemical vapour deposition, said material comprising
• at least a graphene layer and said graphene layer comprising nanocrystals interconnected by amorphous phase;
• and said process **characterised in that** it comprises the following steps:
a) placing the substrate into a vacuum chamber previously set at a pressure lower than 10-4 mbar and under an atmosphere of argon and hydrogen;
b) setting the substrate of step a) to a first substrate temperature T1, wherein T1 reaches values between 400°C and 700°C;
c) activating the plasma and adding a carbon source into the vacuum chamber for a time t1, wherein t1 reaches different values of less than 60 min, obtaining a sample formed by the substrate and the deposited material precursor;
d) setting the sample obtained in step c) to a second substrate temperature T2, wherein T2 is T1 minus T3 wherein T3 reaches values between 30°C and 100°C for a time t2 wherein t2 is higher than t1, and
e) deactivating the plasma and cooling the sample obtained in step d).

2. The process according to the preceding claim, wherein the substrate of step a) is selected from the list consisting of fused silica, silicon carbide, quartz, boron nitride and sapphire.

3. The process according to any of claims 1 or 2, wherein the plasma of step c) is an electron cyclotron resonance plasma.

4. The process according to any of claims 1 to 3, wherein the carbon source of step c) is selected from the list consisting of methane, acetylene, ethylene and a combination thereof.

5. The process according to any of claims 1 to 4, wherein the nanocrystals forming the graphene layers have sizes between 10 nm and 400 nm.

6. The process according to claims 5, wherein the nanocrystals forming the graphene layers have sizes between 10 nm and 300 nm.

7. The process according to any of claims 1 to 6, wherein step e) is carried out under an atmosphere of hydrogen and/or argon.

8. The process according to any of claims 1 to 6, wherein step e) is carried out in a vacuum chamber.

## Patentansprüche

1. Verfahren zum Erhalt eines auf einem Substrat abgeschiedenen Materials, das durch plasmagestützte chemische Gasphasenabscheidung durchgeführt wird, wobei das Material umfasst
• mindestens eine Graphenschicht, wobei die Graphenschicht Nanokristalle umfasst, die durch eine amorphe Phase miteinander verbunden sind;
• und das Verfahren **dadurch gekennzeichnet ist, dass** es die folgenden Schritte umfasst:
a) Anordnen des Substrats in einer Vakuumkammer, die zuvor bei einem Druck von weniger als 10-4 mbar und unter einer Atmosphäre von Argon und Wasserstoff eingestellt war;
b) Einstellen des Substrats von Schritt a) auf eine erste Substrattemperatur T1, wobei T₁ Werte zwischen 400 °C und 700 °C erreicht;
c) Aktivieren des Plasmas und Hinzufügen einer Kohlenstoffquelle in die Vakuumkammer für eine Zeit t1, wobei t1 unterschiedliche Werte von weniger als 60 min erreicht, wobei eine durch das Substrat und den abgeschiedenen Materialvorläufer gebildete Probe erhalten wird;
d) Einstellen der in Schritt c) erhaltenen Probe auf eine zweite Substrattemperatur T2, wobei T2 T1 minus T3 ist, wobei T3 Werte zwischen 30 °C und 100 °C für eine Zeit t2 erreicht, wobei t2 höher als t1 ist, und
e) Deaktivieren des Plasmas und Abkühlen der in Schritt d) erhaltenen Probe.

2. Verfahren nach dem vorstehenden Anspruch, wobei das Substrat von Schritt a) ausgewählt ist aus der Liste bestehend aus Quarzglas, Siliciumcarbid, Quarz, Bornitrid und Saphir.

3. Verfahren nach einem der Ansprüche 1 oder 2, wobei das Plasma von Schritt c) ein Elektronen-Zyklotron-Resonanz-Plasma ist.

4. Verfahren nach einem der Ansprüche 1 bis 3, wobei die Kohlenstoffquelle von Schritt c) ausgewählt ist aus der Liste bestehend aus Methan, Acetylen, Ethylen und einer Kombination davon.

5. Verfahren nach einem der Ansprüche 1 bis 4, wobei die die Graphenschichten bildenden Nanokristalle Größen zwischen 10 nm und 400 nm aufweisen.

6. Verfahren nach Anspruch 5, wobei die die Graphenschichten bildenden Nanokristalle Größen zwischen 10 nm und 300 nm aufweisen.

7. Verfahren nach einem der Ansprüche 1 bis 6, wobei Schritt e) unter einer Atmosphäre von Wasserstoff und/oder Argon durchgeführt wird.

8. Verfahren nach einem der Ansprüche 1 bis 6, wobei Schritt e) in einer Vakuumkammer durchgeführt wird.

## Revendications

1. Procédé d'obtention d'un matériau déposé sur un substrat étant réalisé par dépôt chimique en phase vapeur assisté par plasma, ledit matériau comprenant
• au moins une couche de graphène et ladite couche de graphène comprenant des nanocristaux interconnectés par phase amorphe ;
• et ledit procédé **caractérisé en ce qu'**il comprend les étapes suivantes :
a) le placement du substrat dans une chambre sous vide préalablement réglée à une pression inférieure à 10-4 mbar et sous une atmosphère d'argon et d'hydrogène ;
b) le réglage du substrat de l'étape a) à une première température de substrat T1, dans lequel T1 atteint des valeurs entre 400 °C et 700 °C ;
c) l'activation du plasma et l'ajout d'une source de carbone dans la chambre sous vide pendant un temps t1, dans lequel t1 atteint différentes valeurs inférieures à 60 min, obtenant un échantillon formé du substrat et du précurseur de matériau déposé ;
d) le réglage de l'échantillon obtenu à l'étape c) à une deuxième température de substrat T2, dans lequel T2 est T1 moins T3 dans lequel T3 atteint des valeurs entre 30 °C et 100 °C pendant un temps t2 dans lequel t2 est supérieur à t1, et
e) la désactivation du plasma et le refroidissement de l'échantillon obtenu à l'étape d).

2. Procédé selon la revendication précédente, dans lequel le substrat de l'étape a) est choisi dans la liste constituée de silice fondue, de carbure de silicium, de quartz, de nitrure de bore et de saphir.

3. Procédé selon l'une quelconque des revendications 1 ou 2, dans lequel le plasma de l'étape c) est un plasma à résonance cyclotron électronique.

4. Procédé selon l'une quelconque des revendications 1 à 3, dans lequel la source de carbone de l'étape c) est choisie dans la liste constituée de méthane, d'acétylène, d'éthylène et d'une combinaison de ceux-ci.

5. Procédé selon l'une quelconque des revendications 1 à 4, dans lequel les nanocristaux formant les couches de graphène ont des tailles entre 10 nm et 400 nm.

6. Procédé selon la revendication 5, dans lequel les nanocristaux formant les couches de graphène ont des tailles entre 10 nm et 300 nm.

7. Procédé selon l'une quelconque des revendications 1 à 6, dans lequel l'étape e) est mise en œuvre sous une atmosphère d'hydrogène et/ou d'argon.

8. Procédé selon l'une quelconque des revendications 1 à 6, dans lequel l'étape e) est mise en oeuvre dans une chambre sous vide.
